# DEMANDE DE BREVET EUROPEEN

(11) **EP 1 420 466 A2**
(43) Date de publication de la demande: **19.05.2004**
(21) Numéro de dépôt: 03300176.9
(22) Date de dépôt: 22.10.2003
(51) Int. Cl.: H01L 41/04, F02D 41/20, H02M 3/337

(54) **Dispositif de commande électronique d'un actionneur piézoélectrique ultrasonore**

(30) Priorité: 23.10.2002 FR 0213221
(71) Demandeur: Renault s.a.s., 92100 Boulogne Billancourt (FR)
(72) Inventeur: Ripoll, Christophe, 78220 Viroflay (FR)

(57) **Abrégé**

L'invention concerne un dispositif de commande électronique d'au moins un actionneur piézoélectrique ultrasonore, et plus particulièrement d'un injecteur de carburant à étage piézoélectrique dans un cylindre de moteur thermique d'un véhicule automobile.

Le dispositif selon l'invention comprend une source d'alimentation continue (E), des moyens de conversion continu-alternatif pour induire, à partir de ladite source d'alimentation continue (E), une tension alternative haute fréquence aux bornes d'un enroulement (N1) dit primaire d'un transformateur, un enroulement (N2) dit secondaire dudit transformateur étant fermé sur des moyens de sélection (K1, K2, R3, R4) d'au moins ledit actionneur piézoélectrique par l'intermédiaire de moyens de filtrage (L) de la tension (V2) aux bornes dudit enroulement secondaire, ledit dispositif étant caractérisé en ce que les moyens de conversion c ontinu-alternatif comprennent au moins deux interrupteurs de puissance h aute-fréquence (P1, P3) et au moins un condensateur (Cd).

## Description

La présente invention concerne un dispositif de commande électronique d'au moins un actionneur piézoélectrique ultrasonore, et plus particulièrement d'au moins un injecteur de carburant à étage piézoélectrique dans un cylindre de moteur thermique d'un véhicule automobile.

On connaît déjà dans l'état de la technique des dispositifs de ce type qui comportent une électronique de commande de moyens d'alimentation électrique de l'actionneur pour contrôler la quantité de carburant injectée dans le cylindre.

L'objectif de l'électronique de commande est d'exciter les cellules piézoélectriques pour faire vibrer la structure de l'injecteur permettant ainsi de pulvériser plus finement le carburant en réalisant un ouverture oscillante à fréquence ultrasonore du nez de la buse de l'injecteur. Pour ce faire, on doit générer un signal alternatif de fréquence élevée pour exciter les cellules piézoélectriques.

De façon générale, on utilise dans l'état de la technique une commande en modulation d'amplitude de la tension d'alimentation de l'actionneur piézoélectrique pour contrôler la quantité de carburant injectée dans le moteur. L'électronique de commande génère donc une haute tension périodique (supérieure à une centaine de volts) et haute fréquence (supérieure à une dizaine de kilo Hertz) sur une cellule piézoélectrique à partir d'une source de tension continue, en l'occurrence la batterie d'une automobile ou la sortie d'un convertisseur DC/DC de puissance.

Différents circuits sont proposées dans l'état de la technique qui permettent de commander séquentiellement de 1 à N injecteurs, typiquement 4 ou 6 injecteurs.

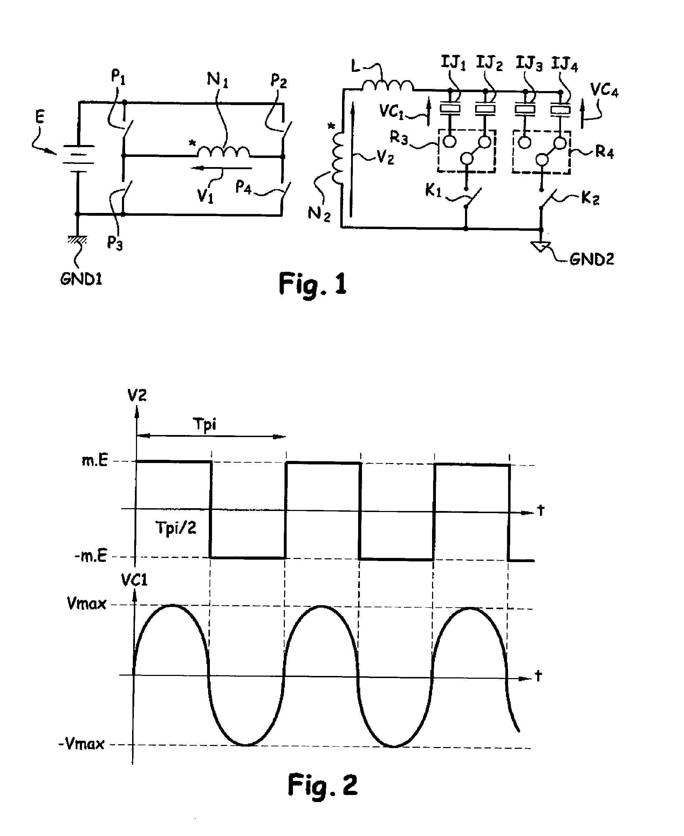

Un circuit permettant de satisfaire cet objectif est représenté à la figure 1 pour piloter quatre injecteurs à étage piézoélectrique.

Soit une source de tension continue E dont la borne moins est connectée à une masse GND1 et alimentant un onduleur de tension en pont constitué par quatre interrupteurs de puissance h aute-fréquence, de type thyristors ou MOSFET par exemple, respectivement P1, P2, P3 et P4. La charge est constituée par une bobine d'induction N1 formant le primaire d'un transformateur. Une bobine d'induction N2 formant le secondaire du transformateur (les astérisques indiquent le sens des enroulements du transformateur) est fermée, par l'intermédiaire d'une seconde bobine d'induction L faisant office de filtre de sortie de la tension de l'enroulement secondaire du transformateur, sur un circuit de sélection de quatre cellules piézoélectriques disposées en parallèle IJ1, IJ2, IJ3 et IJ4 représentant chacune respectivement l'étage piézoélectrique de l'injecteur correspondant.

Le circuit de sélection comprend pour chaque groupe de deux cellules piézoélectriques, IJ1/IJ2, respectivement IJ3/IJ4, un interrupteur de puissance K1, de type thyristor ou MOSFET par exemple, respectivement K2, connecté en série entre une masse GND2 et un élément de commutation R3, respectivement R4, prévu pour commuter, soit la cellule IJ1, respectivement IJ3, soit la cellule IJ2, respectivement IJ4. Il est à noter que les masses GND1 et GND2 peuvent être identiques.

Ainsi, l'électronique de pilotage des quatre injecteurs selon la figure 1 comprend successivement un étage d'alimentation continue, un étage de conversion continu-alternatif haute fréquence, un étage transformateur, un étage de filtrage et un étage de sélection des injecteurs.

Analysons tout d'abord le fonctionnement du circuit de commande de la figure 1 en référence à la figure 2 qui montre un chronogramme de la tension V2 aux bornes de l'enroulement N2 au secondaire du transformateur et un chronogramme de la tension VC1 obtenue aux bornes de la cellule piézoélectrique IJ1 du premier injecteur à commander.

Les interrupteurs de puissance P1 a P4 sont passants deux à deux, respectivement P1 et P4 et P2 et P3, pendant 50% de la période de commande Tₚᵢ :
- de 0 à Tₚᵢ/2, on a P1 et P4 passants, soit : V1=E (V1 étant la tension aux bornes de l'enroulement primaire N1 du transformateur) et V2=m.E, avec m=V2/V1 étant le rapport élévateur du transformateur;
- de T ₚᵢ/2 à Tₚᵢ, on a P2 et P3 passants, soit : V1=-E et V2=-m.E.

On commande donc les interrupteurs P1 et P4 ensemble, puis les interrupteurs P2 et P3 ensemble avec un rapport cyclique de 50%. La tension V2 obtenue est donc rectangulaire.

Les interrupteurs de puissance haute fréquence P1 à P4 permettent en fait de découper à une fréquence élevée (supérieure à 10 kilo Hertz) la tension d'alimentation continue fournie par la source E, et la tension rectangulaire V1 ainsi obtenue aux bornes de l'enroulement primaire N1 permet d'exciter l'enroulement primaire du transformateur dont la tension V2 aux bornes de l'enroulement secondaire va ensuite être filtrée.

Le filtre de sortie constitué par la bobine d'induction L, qui est un filtre passe-bas naturel, est destiné à fournir une tension sensiblement sinusoïdale à partir de la tension rectangulaire V2 délivrée par l'onduleur de tension associé au transformateur de rapport m=V2/V1, d'où le chronogramme de la tension VC1 appliquée aux bornes de l'élément piézoélectrique IJ1.

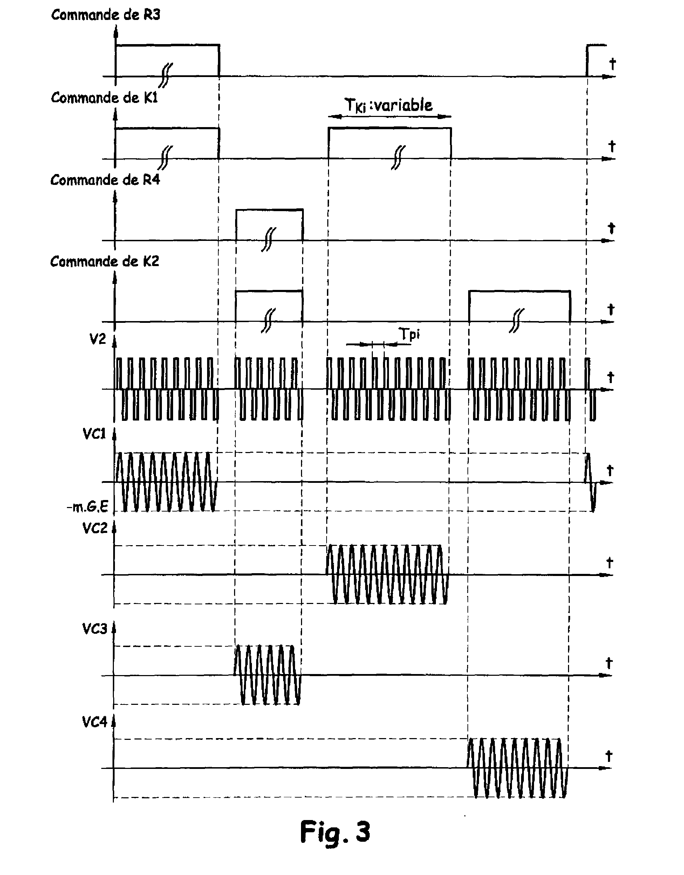

La figure 3 montre les chronogrammes de fonctionnement du système d'injection pour une structure à quatre injecteurs en référence au circuit de la figure 1, et plus précisément les chronogrammes des signaux haute tension VC1, VC2, VC3 et VC4 générés pour exciter les cellules piézoélectriques en fonction des signaux de commande appliqués aux éléments de sélection K1, K2, R3 et R4 permettant de commander séquentiellement les quatre injecteurs.

La période Tₚᵢ dépend exclusivement de la structure des injecteurs. Typiquement, la fréquence Fₚᵢ prend des valeurs comprises entre 10 kHz (kilohertz) et 1 MHz (Mégahertz).

La période T_{Ki}, variable, correspond au temps d'injection et peut varier entre 100 µs et 5ms pour un moteur à quatre injecteurs.

Toutefois, le circuit électronique de pilotage des injecteurs à étage piézoélectrique tel qu'il vient d'être décrit en référence à la figure 1, permettant de générer une haute tension périodique haute fréquence sur une cellule piézoélectrique à partir d'une source de tension continue présente un certain nombre d'inconvénients qui se rapportent essentiellement à complexité du circuit et au coût de fabrication.

En effet, Le circuit de la figure 1 impose d'utiliser quatre interrupteurs de puissance haute fréquence de type thyristor montés en pont, respectivement P1 à P4, pour induire une tension alternative aux bornes du transformateur et générer ainsi les signaux d'excitation haute fréquence des cellules piézoélectriques des injecteurs. La nécessité d'utiliser quatre interrupteurs de ce type n'est pas avantageuse en terme de coût de fabrication.

C'est donc un objectif de l'invention de proposer un dispositif de pilotage électronique d'au moins un actionneur piézoélectrique ultrasonore et plus particulièrement d'au moins un injecteur à étage piézoélectrique qui soit simple à mettre en oeuvre et peu coûteux, permettant de générer une haute tension périodique (supérieure a une centaine de volts) haute fréquence (supérieure à une dizaine de kilo Hertz) à partir d'une source de tension continue pour exciter les cellules piézoélectriques.

Avec cet objectif en vue, l'invention a pour objet un dispositif de commande électronique d'au moins un actionneur piézoélectrique ultrasonore, comprenant une source d'alimentation continue, des moyens de conversion continu-alternatif pour induire, à partir de ladite source d'alimentation continue, une tension alternative haute fréquence aux bornes d'un enroulement dit primaire d'un transformateur, un enroulement dit secondaire dudit transformateur étant fermé sur des moyens de sélection d'au moins ledit actionneur piézoélectrique par l'intermédiaire de moyens de filtrage de la tension aux bornes dudit enroulement secondaire, ledit dispositif étant caractérisé en ce que les moyens de conversion continu-alternatif comprennent au moins deux interrupteurs de puissance haute-fréquence et au moins un condensateur.

D'autres caractéristiques et avantages de la présente invention apparaîtront plus clairement à la lecture de la description suivante donnée à titre d'exemple illustratif et non limitatif et faite en référence aux figures annexées dans lesquelles :
- la figure 1 est un schéma illustrant une électronique de commande pour quatre injecteurs à étage piézoélectrique selon un état de la technique et a déjà été décrite;
- la figure 2 montre un chronogramme de la tension V2 aux bornes de l'enroulement N2 au secondaire du transformateur de la figure 1 et un chronogramme de la tension VC1 obtenue aux bornes de la cellule piézoélectrique IJ1 de la figure 1 et a déjà été décrite;
- la figure 3 montre des chronogrammes de fonctionnement selon l'électronique de commande du système d'injection de la figure 1 et a déjà été décrite;
- la figure 4 illustre le dispositif de commande électronique selon l'invention pour un système d'injection à quatre injecteurs à étage piézoélectrique;
- les figures 5a, 5b et 5c montrent les chronogrammes des tensions Vin, Vcd et V1 de la figure 4;
- la figure 6 montre un second mode de réalisation du dispositif de commande électronique selon l'invention.

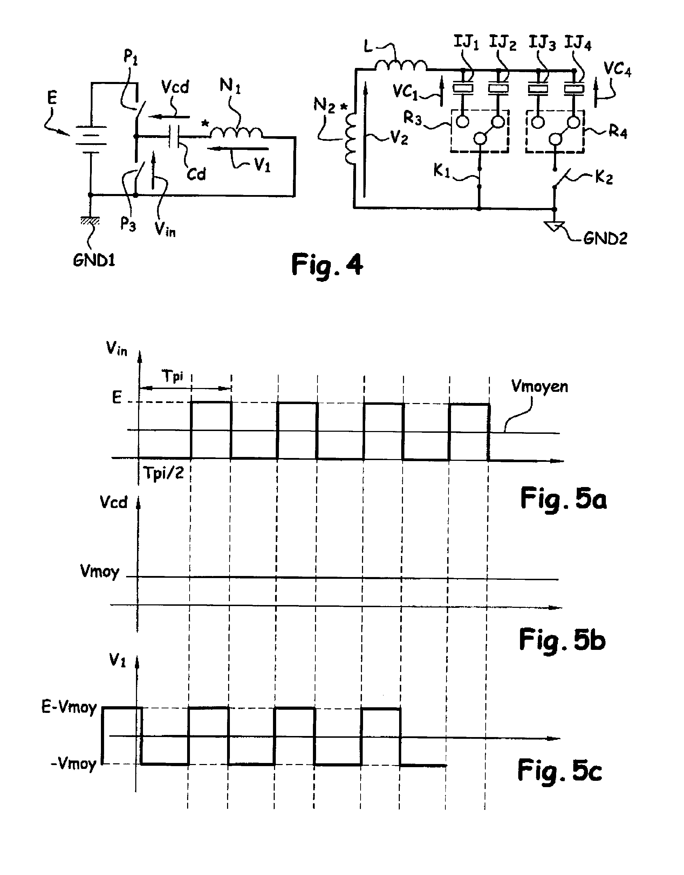

Ainsi, la figure 4 montre le dispositif de commande électronique selon l'invention représenté pour un système d'injection comprenant typiquement quatre injecteurs à étage piézoélectrique.

Le schéma de la figure 4 repose sur une commande des cellules piézoélectriques IJ1 à IJ4, représentant les étages piézoélectriques des quatre injecteurs du système d'injection à commander, avec une structure issue de celle de la figure 1. Les éléments en commun aux deux figures portent les mêmes références.

Ainsi, de façon similaire, on retrouve l'étage d'alimentation constitué par la source d'alimentation continue E, l'étage transformateur constitué par les deux enroulements N1 et N2, l'étage de filtrage constitué par la bobine d'induction L et l'étage de sélection des injecteurs constitué par les interrupteurs de puissance K1 et K2 et les éléments de commutation R3 et R4. Ces éléments et leur fonctionnement ayant déjà été décrits en référence à la figure 1, leur description ne sera pas répétée ici.

En fait, l'invention porte essentiellement sur l'étage de conversion c ontinu-alternatif haute fréquence. En effet, comme déjà vu plus haut, le problème qui se pose pour une telle électronique de commande consiste à générer une haute tension périodique, supérieure à une centaine de volts, et haute fréquence, supérieure à une dizaine de kilo hertz, sur chaque cellule piézoélectrique à commander à partir d'une source de tension continue, en l'occurrence la batterie de la voiture ou la sortie d'un convertisseur continu/continu de puissance.

Pour ce faire, selon l'invention, les interrupteurs de puissance haute fréquence P2 et P4 de la figure 1 sont supprimés et leur fonctionnalité est remplacée par un condensateur Cd. Ainsi, l'association des deux interrupteurs P1 et P3 et du condensateur Cd permet d'induire une tension alternative haute fréquence aux bornes de l'enroulement dit primaire du transformateur, sans qu'il soit nécessaire de mettre en oeuvre quatre interrupteurs de puissance haute fréquence.

Selon ce mode de réalisation de l'invention, le premier interrupteur de puissance haute fréquence P1 est connecté en série avec la source d'alimentation continue E tandis que le deuxième interrupteur de puissance haute fréquence P3 est connecté en parallèle avec la branche composée de la source E et de l'interrupteur P1. Le condensateur Cd est quant à lui connecté en série avec l'enroulement primaire N1 du transformateur, la branche composée du condensateur et de l'enroulement primaire étant elle-même connectée en parallèle d'une part, avec le deuxième interrupteur P3 et, d'autre part, avec la branche composée de la source E et de l'interrupteur P1.

Le fonctionnement des moyens de conversion continu-alternatif comprenant les deux interrupteurs P1, P3 et le condensateur Cd, permettant d'induire une tension alternative haute fréquence aux bornes de l'enroulement primaire du transformateur à partir de la source de tension continue E est expliqué en référence aux chronogrammes des figures 5a à 5c.

La figure 5a montre le chronogramme de la tension Vin aux bornes de la branche composée du second interrupteur de puissance P3.

Soit la période Tₚᵢ de commande des interrupteurs de puissance P1 et P3. la période Tₚᵢ dépend exclusivement de la structure des injecteurs. La fréquence Fₚᵢ prend typiquement des valeurs comprises entre 10kHz et 1MHz pour les injecteurs à étage piézoélectrique ultrasonore utilisés classiquement.
- de 0 à Tₚᵢ/2, on a P3 passant et P1 non passant, soit : Vin=0.
- de Tₚᵢ/2 à Tpi, on a P1 passant et P3 non passant, soit : Vin=E.

La tension Vin obtenue est donc une tension alternative rectangulaire comme représentée à la figure 5a et possède une composante moyenne Vmoy continue.

Le condensateur Cd n'a pas le temps de se charger ou de se décharger au rythme du signal Vin : sa charge (tension) va en fait correspondre à la valeur moyenne continue Vmoy du signal, comme représenté à la figure 5b.

La tension V1 aux bornes de l'enroulement primaire N1 du transformateur correspond à la différence des tensions Vin et Vcd, d'où, comme représenté à la figure 5c :
- de 0 à Tₚᵢ/2, V1=-Vmoy.
- de Tₚᵢ/2 à Tₚᵢ, V1=E-Vmoy.

Ainsi, les deux interrupteur de puissance haute fréquence associés au condensateur Cd permettent d'induire une tension alternative haute fréquence à valeur moyenne nulle aux bornes de l'enroulement primaire du transformateur.

La valeur de cette tension alternative va être élevée dans l'étage transformateur, puis la tension alternative rectangulaire élevée obtenue va être filtrée pour donner une tension sensiblement sinusoïdale comme expliqué en référence à la figure 1. Ainsi, le dispositif de commande électronique selon l'invention permet de générer un signal sinusoïdal haute tension de fréquence élevée pour exciter séquentiellement en fonction de leur sélection les cellules piézoélectriques IJ1 à IJ4 des injecteurs.

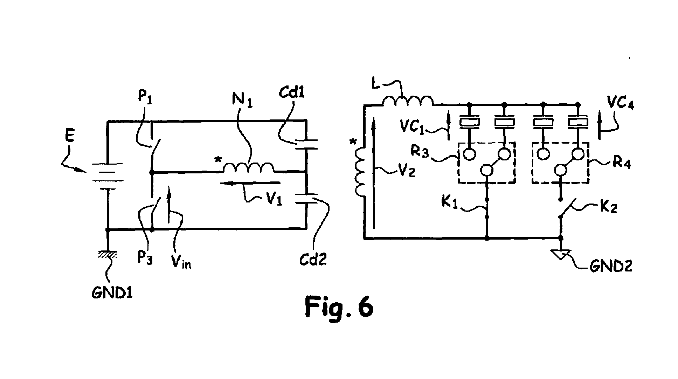

La figure 6 illustre un second mode de réalisation du dispositif de commande électronique selon l'invention. Dans cette variante, les moyens de conversion c ontinu-alternatif mettent en oeuvre deux interrupteurs de puissance haute fréquence P1 et P3 et deux condensateurs Cd1 et Cd2 formant un montage en pont.

L'invention permet avantageusement de n'utiliser que deux interrupteurs de puissance haute fréquence de type Pi pour générer le signal alternatif de fréquence élevée pour exciter les cellules piézoélectriques à partir de la source d'alimentation continue et permet également de réduire les coûts de tels dispositifs de commande électronique par l'utilisation d'au moins un condensateur à la place de deux interrupteurs de type Pi.

## Revendications

1. Dispositif de commande électronique d'au moins un actionneur piézoélectrique ultrasonore (IJ1, IJ2, IJ3, IJ4), comprenant une source d'alimentation continue (E), des moyens de conversion c ontinu-alternatif pour induire, à partir de ladite source d'alimentation continue (E), une tension alternative haute fréquence aux bornes d'un enroulement (N1) dit primaire d'un transformateur, un enroulement (N2) dit secondaire dudit transformateur étant fermé sur des moyens de sélection (K1, K2, R3, R4) d'au moins ledit actionneur piézoélectrique par l'intermédiaire de moyens de filtrage (L) de la tension (V2) aux bornes dudit enroulement secondaire, ledit dispositif étant **caractérisé en ce que** les moyens de conversion continu-alternatif comprennent au moins deux interrupteurs de puissance h aute-fréquence (P1, P3) et au moins un condensateur (Cd).

2. Dispositif selon la revendication 1, **caractérisé en ce que** les moyens de conversion continu-alternatif comprennent un premier interrupteur de puissance haute fréquence (P1) connecté en série avec la source d'alimentation continu (E), un second interrupteur de puissance haute fréquence (P3) connecté en parallèle avec la branche composée de ladite source d'alimentation continue (E) et dudit premier interrupteur (P1), ledit condensateur (Cd) étant connecté en série avec l'enroulement primaire (N1) du transformateur, et la branche composée du condensateur (Cd) et de l'enroulement primaire (N1) étant elle-même connectée en parallèle d'une part, avec ledit deuxième interrupteur (P3) et, d'autre part, avec ladite branche composée de ladite source (E) et dudit premier interrupteur (P1).

3. Dispositif selon la revendication 1, **caractérisé en ce que** les moyens de conversion continu-alternatif comprennent deux interrupteurs de puissance haute fréquence (P1, P3) et deux condensateurs (Cdl, Cd2) formant un montage en pont.

4. Dispositif selon l'une des revendications précédentes, **caractérisé en ce que** les moyens de filtrage au secondaire du transformateur comprennent une bobine d'induction (L).

5. Dispositif selon l'une des revendications précédentes, **caractérisé en ce que** les moyens de sélection comprennent au moins un interrupteur de puissance haute fréquence (K1, K2) et au moins un élément de commutation (R3, R4).

6. Dispositif selon l'une des revendications précédentes, **caractérisé en ce que** les interrupteurs de puissance haute fréquence comprennent un thyristor.
